(19) Europäisches Patentamt
European Patent Office
Office européen des brevets

(11) **EP 4 765 247 A1**

(12) **EUROPEAN PATENT APPLICATION**
published in accordance with Art. 153(4) EPC

(43) Date of publication:
**24.06.2026 Bulletin 2026/26**

(21) Application number: **24875005.1**

(22) Date of filing: **04.10.2024**

(51) International Patent Classification (IPC):
*H01M 4/525* (2010.01)       *H01M 4/505* (2010.01)
*C01G 53/00* (2025.01)       *H01M 4/131* (2010.01)
*H01M 10/052* (2010.01)       *H01M 4/02* (2006.01)

(52) Cooperative Patent Classification (CPC):
**C01G 53/00; H01M 4/02; H01M 4/131; H01M 4/505;
H01M 4/525; H01M 10/052;** Y02E 60/10

(86) International application number:
**PCT/KR2024/015134**

(87) International publication number:
**WO 2025/075450 (10.04.2025 Gazette 2025/15)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.10.2023 KR 20230132929**

(71) Applicant: **LG Energy Solution, Ltd.
Seoul 07335 (KR)**

(72) Inventors:
• **KIM, Yeong Jin
Daejeon 34122 (KR)**

• **KIM, Ji Hye
Daejeon 34122 (KR)**
• **JUNG, Hae Jung
Daejeon 34122 (KR)**
• **HEO, Jong Wook
Daejeon 34122 (KR)**
• **YUN, So Yeong
Daejeon 34122 (KR)**
• **PARK, Byung Chun
Daejeon 34122 (KR)**

(74) Representative: **Hoffmann Eitle
Patent- und Rechtsanwälte PartmbB
Arabellastraße 30
81925 München (DE)**

(54) **POSITIVE ELECTRODE MATERIAL POWDER AND METHOD FOR MANUFACTURING POSITIVE ELECTRODE MATERIAL POWDER**

(57)    The present invention relates to positive electrode material powder including a lithium composite transition metal oxide including nickel, cobalt, manganese, and zirconium, wherein a degree of single particle formation defined by Equation 1 is in a range of 2.5 to 4.5, and a method of preparing positive electrode material powder, in which four-times sintering and a zirconium doping process are included and $D_{50}$ of the transition metal-containing precursor is controlled to 95% or less of $D_{50}$ of the positive electrode material powder, as a method of preparing the same.

[FIG. 1]

EP 4 765 247 A1

**Description**

## TECHNICAL FIELD

This application claims priority from Korean Patent Application Nos. 10-2023-0132929, filed on October 5, 2023, and 10-2024-0134975, filed on October 4, 2024, the disclosures of which are incorporated by reference herein.

The present invention relates to positive electrode material powder with controlled particle strength and degree of single particle formation, a method of preparing the same, and a positive electrode and a lithium secondary battery which include the positive electrode material powder.

## BACKGROUND ART

A lithium secondary battery is generally composed of a positive electrode, a negative electrode, a separator, and an electrolyte, and the positive electrode and the negative electrode respectively include active materials capable of intercalating and deintercalating lithium ions.

Among them, lithium composite transition metal oxides containing two or more types of transition metals, which have been developed to compensate for problems of lithium transition metal oxides containing nickel (Ni), cobalt (Co), or manganese (Mn) alone, are in the spotlight as the positive electrode active material, and, among them, a lithium nickel cobalt manganese oxide containing Ni, Co, and Mn has been widely used in the field of electric vehicle batteries.

A conventional lithium nickel cobalt manganese oxide was generally in a form of a spherical secondary particle in which tens to hundreds of primary particles were aggregated. However, in a case in which the lithium nickel cobalt manganese oxide in the form of a secondary particle, in which many primary particles are aggregated as described above, is used, there is a problem in that particle breakage, in which the primary particles fall off in a rolling process during preparation of the positive electrode, is likely to occur and cracks occur in the particles during charge and discharge. In a case in which the particle breakage or cracking of the positive electrode active material occurs, since a contact area with an electrolyte solution is increased, active material degradation and gas generation due to a side reaction with the electrolyte solution are increased and, as a result, there is a problem in that life characteristics are degraded.

To solve the above-described problem, a technique of preparing a positive electrode active material in a form of a single particle rather than a secondary particle by increasing sintering temperature during the preparation of the lithium nickel cobalt manganese oxide has been proposed. The positive electrode active material in the form of a single particle is advantageous in that there is less side reaction with the electrolyte solution due to a smaller contact area with the electrolyte solution than a conventional positive electrode active material in the form of a secondary particle, and there is less particle breakage during the preparation of an electrode due to excellent particle strength.

However, an aggregation phenomenon may occur between a plurality of particles in a sintering process for preparing the positive electrode active material in the form of a single particle, wherein it may cause a non-uniform particle size distribution to cause problems such as a degradation of life characteristics and an increase in resistance.

As a solution to the problem of non-uniform particle size of the positive electrode active material, a separate post-treatment process, such as grinding, may be introduced after the sintering process, and accordingly, a uniform particle distribution of the positive electrode active material may be possible.

However, fine powder may be increased due to an excessive post-treatment process, and this increase in the fine powder may rather have a negative effect on high-temperature performance of the lithium secondary battery.

## DISCLOSURE OF THE INVENTION

## TECHNICAL PROBLEM

The present invention aims to contribute to improve high-temperature durability and lifetime of a lithium secondary battery by providing positive electrode material powder with controlled particle strength and degree of single particle formation and a method of preparing the same.

## TECHNICAL SOLUTION

[1] The present invention provides positive electrode material powder which includes a lithium composite transition metal oxide including nickel, cobalt, manganese, and zirconium, wherein a degree of single particle formation defined by Equation 1 is in a range of 2.5 to 4.5.

[Equation 1]

$$\frac{\sum_{i=1}^{n} \frac{4\pi}{3} \times R_i^3}{n}$$

In Equation 1,

$R_i$ is a radius ($\mu$m) of an $i^{th}$ grain which is measured when an electrode prepared by using the positive electrode material powder is analyzed by electron backscatter diffraction (EBSD) after an ion-milling treatment, and
n is the total number of grains measured by the EBSD analysis, wherein n is in a range of 350 to 450.

[2] The present invention provides the positive electrode material powder of [1] above, wherein a change in pellet density defined by Equation 2 is 2.5 or less.

[Equation 2]

$$\{(P_{12ton} - P_{1.5ton})/10.5\} \times 20$$

In Equation 2,

$P_{1.5ton}$ is pellet density (g/cc) obtained by dividing the weight of the positive electrode material powder by the volume of a pellet prepared by putting the positive electrode material powder in a circular mold with a diameter of 13 mm and pressing the powder with a force of 1,500 kgf, and
$P_{12ton}$ is pellet density (g/cc) obtained by dividing the weight of the positive electrode material powder by the volume of the pellet prepared by putting the positive electrode material powder in a circular mold with a diameter of 13 mm and pressing the powder with a force of 12,000 kgf.

[3] The present invention provides the positive electrode material powder of [1] or [2] above, wherein a weight of the zirconium is in a range of 300 ppm to 1,000 ppm based on a total weight of the lithium composite transition metal oxide.

[4] The present invention provides the positive electrode material powder of at least one of [1] to [3] above, wherein $D_{50}$ is in a range of 3 $\mu$m to 6 $\mu$m.

[5] The present invention provides the positive electrode material powder of at least one of [1] to [4] above, wherein tap density is in a range of 1.8 g/cc to 2.3 g/cc.

[6] The present invention provides the positive electrode material powder of at least one of [1] to [5] above, wherein an average grain diameter is in a range of 0.5 $\mu$m to 4.0 $\mu$m.

[7] The present invention provides the positive electrode material powder of at least one of [1] to [6] above, wherein, when the positive electrode material powder is put in a circular mold with a diameter of 13 mm and pressed with a force of 12,000 kgf, a generation rate of fine powder having a particle diameter of 1 $\mu$m or less is 2 vol% or less based on a total volume of the positive electrode material powder.

[8] The present invention provides the positive electrode material powder of at least one of [1] to [7] above, wherein the lithium composite transition metal oxide has a composition of Formula 1.

[Formula 1]     $Li_{1+x}(Ni_aCo_bMn_cZr_dM1_e)O_2$

In Formula 1,

M1 is at least one selected from the group consisting of aluminum (Al), titanium (Ti), tungsten (W), molybdenum (Mo), niobium (Nb), copper (Cu), iron (Fe), vanadium (V), chromium (Cr), zinc (Zn), indium (In), tantalum (Ta), yttrium (Y), lanthanum (La), strontium (Sr), gallium (Ga), scandium (Sc), gadolinium (Gd), samarium (Sm), calcium (Ca), cerium (Ce), magnesium (Mg), and boron (B), and
x, a, b, c, d, and e respectively satisfy $0 \leq x \leq 0.50$, $0.55 \leq a < 1$, $0 < b \leq 0.40$, $0 < c \leq 0.40$, $0 < d \leq 0.01$, $0 \leq e \leq 0.10$, and $a+b+c+d+e=1$.

[9] The present invention provides the positive electrode material powder of at least one of [1] to [8] above, wherein an amount of the nickel among metals excluding lithium of the lithium composite transition metal oxide is 70 mol% or more.

[10] The present invention provides a method of preparing positive electrode material powder which includes: a first step of preparing a first mixture by mixing a transition metal-containing precursor including nickel, cobalt, and manganese with a lithium raw material;

a second step of preparing a first sintered body by performing primary sintering on the first mixture at 500°C to 700°C and performing secondary sintering at 700°C to 950°C;

a third step of preparing a second mixture by mixing the first sintered body with a zirconium raw material;

a fourth step of preparing a second sintered body in a form of a single particle or a pseudo-single particle by performing tertiary sintering on the second mixture at 650°C to 900°C and performing quaternary sintering at 650°C to 950°C; and

a fifth step of milling the sintered body,

wherein the method satisfies Equation 3.

$$[\text{Equation 3}]$$

$$A \leq 0.95B$$

In Formula 3,

A is $D_{50}$ of the transition metal-containing precursor, and

B is $D_{50}$ of the positive electrode material powder.

[11] The present invention provides the method of [10] above, wherein the milling of the fifth step is performed at a speed of 1,500 rpm to 3,000 rpm.

[12] The present invention provides the method of [10] or [11] above, wherein B of Equation 3 is in a range of 3 $\mu$m to 6 $\mu$m.

[13] The present invention provides a positive electrode including the positive electrode material powder of at least one of [1] to [9] above.

[14] The present invention provides a lithium secondary battery including the positive electrode of [13] above; a negative electrode including a negative electrode active material; a separator disposed between the positive electrode and the negative electrode; and an electrolyte.

## ADVANTAGEOUS EFFECTS

Since positive electrode material powder according to the present invention has a high degree of single particle formation and excellent particle strength, there is little particle breakage during rolling. Thus, a positive electrode having high energy density per unit volume may be prepared by increasing rolling intensity when the positive electrode material powder is used.

Also, in a case in which fine powder is generated due to particle breakage during rolling, a contact area with an electrolyte solution is increased to increase a gas generation amount due to a side reaction, and this may lead to degradation of a positive electrode material and degradation of life characteristics of a battery, but since the positive electrode material powder according to the present invention has a low fine powder generation rate during rolling, it may contribute to solve this problem.

When following a method of preparing positive electrode material powder according to the present invention, since it is easy to achieve a desired particle size while adjusting intensity of a milling process to low, problems of decrease in sphericity and fine powder generation due to milling may be solved.

## BRIEF DESCRIPTION OF THE DRAWINGS

FIG. 1 is a graph in which a change in pellet density according to a pressing force is measured for positive electrode material powders of an example and comparative examples.

FIG. 2 is a graph in which capacity retention according to high-temperature cycles is measured for cells including the positive electrode material powders of the example and the comparative examples.

FIG. 3 is a graph in which a gas generation amount during high-temperature storage is measured for the cells including the positive electrode material powders of the example and the comparative examples.

FIG. 4 is a scanning electron microscope image of positive electrode material powder prepared in Example 1.

FIG. 5 is a scanning electron microscope image of positive electrode material powder prepared in Comparative Example 1.

FIG. 6 is a scanning electron microscope image of positive electrode material powder prepared in Comparative Example 2.

FIG. 7 is a scanning electron microscope image of positive electrode material powder prepared in Comparative Example 3.

**MODE FOR CARRYING OUT THE INVENTION**

Hereinafter, the present invention will be described in more detail to allow for a clearer understanding of the present invention.

In the present invention, a "grain" is a particle unit having the same crystal orientation, wherein it is a smallest particle unit recognized as one body in an electron backscatter diffraction (EBSD) map image. A size of the grain may be measured by image analysis of an EBSD map.

In the present invention, a "single particle" means a particle composed of one nodule, and a "pseudo-single particle" means a composite particle of 30 or less nodules.

The "nodule" is a sub-particle unit constituting the single particle and the pseudo-single particle, wherein the nodule may be a single crystal without a crystalline grain boundary, or may be a polycrystal in which grain boundaries do not exist in appearance when observed by using a scanning electron microscope with a field of view of 5,000 times to 20,000 times.

In the present invention, a "particle" is a concept including any one or all of the single particle, the pseudo-single particle, a primary particle, the nodule, and a secondary particle.

In the present invention, "$D_{50}$" means a particle diameter corresponding to a cumulative volume of 50% in a volume cumulative particle size distribution of corresponding powder, wherein it may be measured using a laser diffraction method. For example, after dispersing positive electrode material powder in a dispersion medium, the dispersion medium is introduced into a commercial laser diffraction particle size measurement instrument (e.g., Malvern Panalytical Ltd., Mastersizer 3000) and irradiated with ultrasonic waves of about 28 kHz at an output of 60 W to obtain a volume cumulative particle size distribution graph, and the $D_{50}$ may be measured by a method in which a particle diameter at a cumulative volume of 50% in the obtained volume cumulative particle size distribution graph is obtained.

In the present invention, "pellet density" may be obtained by a method in which, after a certain amount of a sample is put in a cylindrical load cell or a circular mold and a force is applied to press it into a shape of a pellet, density is calculated from volume and weight of the pellet. For example, the pellet density may be measured using an automatic pellet press (Auto Pellet Press, 3887.4) by Carver, Inc.

In the present invention, "tap density" may be measured by a method generally used in the art, as a method for measuring a degree of packing the sample per unit volume. For example, the tap density may be density (sample weight/volume) which is calculated from an amount of volume changed by applying a constant force to a measurement container containing the sample in accordance with measuring equipment and method specified in ASTM B527. Specifically, the tap density may be measured by vibrating horizontally until a force of 108 N is applied using a GEOPYC 1360 tap density analyzer by Micromeritics Instrument Corporation.

Hereinafter, each component of the present invention will be described in more detail.

**Positive Electrode Material Powder**

Positive electrode material powder according to an embodiment of the present invention includes a lithium composite transition metal oxide including nickel, cobalt, manganese, and zirconium. Also, the positive electrode material powder has a degree of single particle formation defined by Equation 1 below of 2.5 to 4.5.

[Equation 1]

$$\frac{\sum_{i=1}^{n} \frac{4\pi}{3} \times R_i^3}{n}$$

In Equation 1,

R$_i$ is a radius (μm) of an i$^{th}$ grain which is measured when an electrode prepared by using the positive electrode material powder is analyzed by electron backscatter diffraction (EBSD) after an ion-milling treatment, and

n is the total number of grains measured by the EBSD analysis, wherein n is in a range of 350 to 450.

Since the positive electrode material powder according to the present invention includes positive electrode active material particles in a form of a single particle or a pseudo-single particle, it is advantageous in that there is less side reaction with an electrolyte solution due to a smaller contact area with the electrolyte solution than a conventional positive electrode active material in a form of a secondary particle and there is less particle breakage during the preparation of the electrode due to excellent particle strength.

In preparing the positive electrode material powder including the positive electrode active material particles in the form of a single particle or a pseudo-single particle, a grinding process, such as milling, is performed after a sintering step to obtain a target particle size, wherein if a precursor having a size larger than the target size is used or an aggregation phenomenon between the particles is intensified in a high-temperature sintering process that is used to form the single particle, the grinding process must be performed under conditions capable of applying a strong impact. In this case, a large amount of fine powder is generated and sphericity may be decreased due to the strong grinding process.

As described above, since this may lead to problems such as a reduction in high-temperature lifetime and an increase in gas generation amount, the present invention aims to solve these problems.

Specifically, the present inventors have confirmed that the degree of single particle formation defined by Equation 1 may be controlled within an optimal numerical range by relaxing milling conditions by adjusting D$_{50}$ of the precursor to 95% or less of D$_{50}$ of the target positive electrode material powder and doping with zirconium as a flux contributing to particle growth.

More specifically, the positive electrode material powder may have a degree of single particle formation defined by Equation 1 of 2.6 or more, 2.8 or more, or 3.0 or more. As the degree of single particle formation increases, it means that there are more positive electrode active material particles with a small number of grains, that is, more particles in the form of a single particle, in the positive electrode material powder, and thus, there is an effect of improving high-temperature performance. However, in a case in which the degree of single particle formation is greater than 4.5, since resistance may be excessively increased to reduce output and capacity characteristics, the degree of single particle formation may be 4.5 or less, 4.0 or less, or 3.5 or less.

R$_i$ of Equation 1 may be in a range of 0.4 to 2.5, 0.8 to 2.0, or 0.8 to 1.8. The grain radius substituted in Equation 1 is a value measured in μm units, but is a dimensionless number that does not include units.

Also, an average grain diameter measured by EBSD of the positive electrode material powder may be in a range of 0.5 μm to 4.0 μm, preferably 0.8 μm to 3.0 μm, and more preferably 2.2 μm to 2.5 μm. When the average grain diameter of the positive electrode material powder satisfies the above range, that is, when large grains are formed, since grain boundaries are reduced and a surface area is reduced, a rock salt phase generated in the lithium composite transition metal oxide during cycling or exposure to moisture is reduced, and thus, resistance characteristics are more excellent.

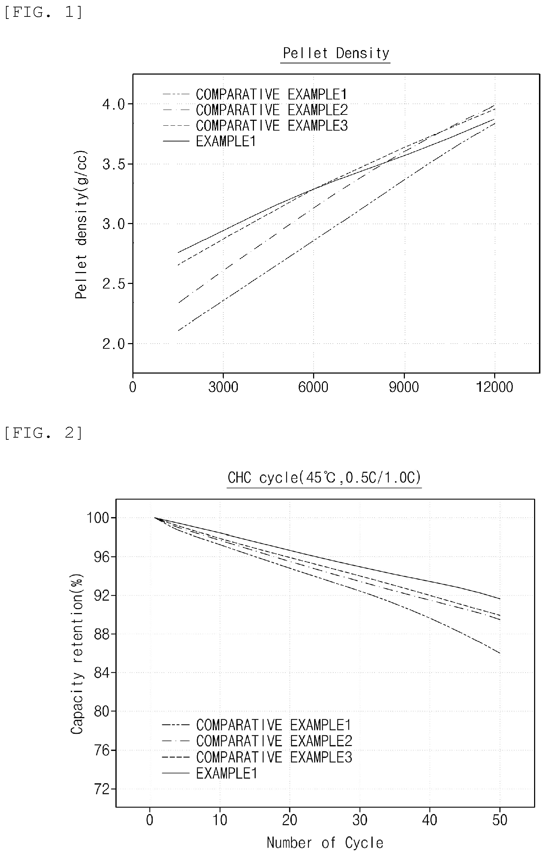

The positive electrode material powder may have a change in pellet density defined by Equation 2 below of 2.5 or less, preferably 2.3 or less, and more preferably 2.2 or less. A low change in pellet density means that a slope of a graph measuring the pellet density according to a load as in FIG. 1 is gradual, and, since this means that the pellet density is less affected by a pressing force, it may be interpreted as exhibiting excellent particle strength characteristics.

$$[\text{Equation 2}]$$

$$\{(P_{12ton} - P_{1.5ton})/10.5\} \times 20$$

In Equation 2,

P$_{1.5ton}$ is pellet density (g/cc) obtained by dividing the weight of the positive electrode material powder by the volume of a pellet prepared by putting the positive electrode material powder in a circular mold with a diameter of 13 mm and pressing the powder with a force of 1,500 kgf, and

P$_{12ton}$ is pellet density (g/cc) obtained by dividing the weight of the positive electrode material powder by the volume of the pellet prepared by putting the positive electrode material powder in a circular mold with a diameter of 13 mm and pressing the powder with a force of 12,000 kgf.

P$_{1.5ton}$ of Equation 2 may be in a range of 2.5 to 3.0, specifically, 2.6 to 2.9, and P$_{12ton}$ may be in a range of 3.6 to 4.1, specifically, 3.7 to 4.0.

The pellet density substituted in Equation 2 is a value measured in g/cc units, but is a dimensionless number that does not include units.

The positive electrode material powder may be a single particle composed of one nodule and/or a pseudo-single particle that is a composite of 30 or less nodules, preferably 2 to 20 nodules, and more preferably 2 to 10 nodules, or may be in a form including them. Preferably, the positive electrode material powder according to the present invention may be composed of a combination of positive electrode active material particles in the form of a single particle and a pseudo-single particle. The reason for this is that, in a case in which the number of nodules constituting the positive electrode active material particle is greater than 30, particle breakage may be increased during the preparation of the electrode and occurrence of internal cracks due to volume expansion/contraction of the nodules may be increased during charge and discharge to reduce an effect of improving high-temperature life characteristics and high-temperature storage characteristics.

Also, $D_{50}$ of the positive electrode material powder may be in a range of 3.0 $\mu$m to 6.0 $\mu$m, preferably, 3.5 $\mu$m to 4.7 $\mu$m. In order to ensure processability during the preparation of the electrode, it is desirable that the $D_{50}$ is 3.0 $\mu$m or more, but in order to improve electrolyte solution impregnability and prevent an excessive increase in resistance, it is desirable that the $D_{50}$ is 6.0 $\mu$m or less.

Furthermore, when the positive electrode material powder is put in a circular mold with a diameter of 13 mm and pressed with a force of 12,000 kgf, a generation rate of fine powder having a particle diameter of 1 $\mu$m or less may be 2 vol% or less, preferably 1.8 vol% or less, and more preferably 1.5 vol% or less based on a total volume of the positive electrode material powder. In this case, since it means that the particle has excellent durability against rolling, energy density may not only be increased by increasing rolling intensity, if necessary, but also the amount of gas generated due to a side reaction during operation or storage at high temperatures may be reduced and lifetime may be improved.

According to an embodiment of the present invention, an amount of nickel among metals excluding lithium of the lithium composite transition metal oxide may be 70 mol% or more, preferably 80 mol% or more, and more preferably 90 mol% or more, but may be 99 mol% or less. In this case, there is an advantage of being able to achieve high capacity.

Also, the lithium composite transition metal oxide may have a composition of Formula 1 below.

[Formula 1] $\quad$ $Li_{1+x} (Ni_aCo_bMn_cZr_dM1_e) O_2$

In Formula 1,

M1 is at least one selected from the group consisting of aluminum (Al), titanium (Ti), tungsten (W), molybdenum (Mo), niobium (Nb), copper (Cu), iron (Fe), vanadium (V), chromium (Cr), zinc (Zn), indium (In), tantalum (Ta), yttrium (Y), lanthanum (La), strontium (Sr), gallium (Ga), scandium (Sc), gadolinium (Gd), samarium (Sm), calcium (Ca), cerium (Ce), magnesium (Mg), and boron (B), and

x, a, b, c, d, and e respectively satisfy $0 \leq x \leq 0.50$, $0.55 \leq a < 1$, $0 < b \leq 0.40$, $0 < c \leq 0.40$, $0 < d \leq 0.01$, $0 \leq e \leq 0.10$, and a+b+c+d+e=1.

1+x represents a molar ratio of lithium in the lithium composite transition metal oxide, wherein x may satisfy $0 \leq x \leq 0.20$ or $0 \leq x \leq 0.10$. When the molar ratio of the lithium satisfies the above range, a crystal structure may be stably formed.

a represents a molar ratio of nickel among total metals excluding lithium in the lithium composite transition metal oxide, wherein a may satisfy $0.80 \leq a < 1$, $0.90 \leq a < 1$, or $0.93 \leq a < 1$. When the molar ratio of the nickel satisfies the above range, high energy density may be exhibited to achieve high capacity.

b represents a molar ratio of cobalt among the total metals excluding lithium in the lithium composite transition metal oxide, wherein b may satisfy $0 < b \leq 0.15$, $0 < b \leq 0.08$, or $0 < b \leq 0.05$. When the molar ratio of the cobalt satisfies the above range, good resistance characteristics and output characteristics may be achieved.

c represents a molar ratio of manganese among the total metals excluding lithium in the lithium composite transition metal oxide, wherein c may satisfy $0 < c \leq 0.10$, $0 < c \leq 0.05$, or $0 < c \leq 0.03$. When the molar ratio of the manganese satisfies the above range, structural stability of the positive electrode material is excellent.

d represents a molar ratio of zirconium among the total metals excluding lithium in the lithium composite transition metal oxide, wherein d may satisfy $0 < d \leq 0.008$, $0 < d \leq 0.005$, or $0 < d \leq 0.001$.

e represents a molar ratio of element M1 among the total metals excluding lithium in the lithium composite transition metal oxide, wherein e may be adjusted as needed.

A weight of the zirconium may be 300 ppm or more, 400 ppm or more, or 500 ppm or more based on a total weight of the lithium composite transition metal oxide, and, in this case, an effect of particle growth due to a flux effect may not only be observed, but it is also desirable in terms of preventing cation mixing between lithium ions and nickel ions. However, considering that excessive doping may cause a decrease in capacity and gelation during subsequent preparation of a slurry, it is desirable that the weight of the zirconium is not greater than 1,000 ppm.

**Method of Preparing Positive Electrode Material Powder**

Hereinafter, a method of preparing positive electrode material powder according to the present invention will be described.

The method of preparing positive electrode material powder according to the present invention includes: a first step of preparing a first mixture by mixing a transition metal-containing precursor including nickel, cobalt, and manganese with a lithium raw material; a second step of preparing a first sintered body by performing primary sintering on the first mixture at 500°C to 700°C and performing secondary sintering at 700°C to 950°C; a third step of preparing a second mixture by mixing the first sintered body with a zirconium raw material; a fourth step of preparing a second sintered body in a form of a single particle or a pseudo-single particle by performing tertiary sintering on the second mixture at 650°C to 900°C and performing quaternary sintering at 650°C to 950°C; and a fifth step of milling the second sintered body, wherein the method satisfies Equation 3 below at the same time.

$$[\text{Equation 3}]$$

$$A \leq 0.95B$$

In Formula 3,

A is $D_{50}$ of the transition metal-containing precursor, and
B is $D_{50}$ of the positive electrode material powder.

As described above, since the $D_{50}$ of the precursor is adjusted to 95% or less of the $D_{50}$ of the target positive electrode material powder, milling conditions performed after sintering may be relaxed to reduce an amount of impact applied, and thus, the fine powder generation rate may eventually be reduced and the sphericity may be increased. Specifically, A may satisfy $0.85B \leq A \leq 0.95B$, or $0.90B \leq A \leq 0.93B$.

Next, each step will be described.

1) First Step

First, a first mixture is prepared by mixing a transition metal-containing precursor including nickel, cobalt, and manganese with a lithium raw material in a reactor.

The transition metal-containing precursor may be in a form of a hydroxide, oxide or carbonate, may specifically be in the form of a hydroxide, and may more specifically have a composition of Formula 2 below.

[Formula 2]    $Ni_{a1}Co_{b1}Mn_{c1}M1_{d1}(OH)_2$

In Formula 2,

M1 is at least one selected from the group consisting of Al, Ti, W, Mo, Nb, Cu, Fe, V, Cr, Zn, In, Ta, Y, La, Sr, Ga, Sc, Gd, Sm, Ca, Ce, Mg, and B,
x, a, b, c, d, and e respectively satisfy $0 \leq x \leq 0.50$, $0.55 \leq a < 1$, $0 < b \leq 0.40$, $0 < c \leq 0.40$, $0 < d \leq 0.01$, $0 \leq e \leq 0.10$, and $a+b+c+d+e=1$.

a1 represents a molar ratio of nickel among total metals in the precursor, wherein a1 may satisfy $0.80 \leq a1 < 1$, $0.90 \leq a1 < 1$, or $0.93 \leq a1 < 1$.

b1 represents a molar ratio of cobalt among the total metals in the precursor, wherein b1 may satisfy $0 < b1 \leq 0.15$, $0 < b1 \leq 0.08$, or $0 < b1 \leq 0.05$.

c1 represents a molar ratio of manganese among the total metals in the precursor, wherein c1 may satisfy $0 < c1 \leq 0.10$, $0 < c1 \leq 0.05$, or $0 < c1 \leq 0.03$.

d1 represents a molar ratio of element M1 among the total metals in the precursor, wherein d1 may satisfy $0 < d1 \leq 0.08$, $0 < d1 \leq 0.05$, or $0 < d1 \leq 0.03$.

The method of preparing positive electrode material powder may further include a step of preparing the transition metal-containing precursor. Specifically, the method may further include a step of preparing a transition metal-containing solution by dissolving a nickel precursor, a cobalt precursor, and a manganese precursor in a solvent in a reactor; and a step of forming a transition metal-containing precursor including nickel, cobalt, and manganese by performing a co-precipitation reaction while supplying the transition metal-containing solution, an ammonium cationic complexing agent, and a basic compound. An oxidizing agent or oxygen gas may be further added during the co-precipitation reaction, if necessary.

The transition metal precursor may be acetic acid salts, carbonates, nitrates, sulfates, halides, or sulfides of each transition metal.

Specifically, the nickel precursor may be at least one selected from the group consisting of NiO, Ni-$CO_3 \cdot 2Ni(OH)_2 \cdot 4H_2O$, $NiC_2O_2 \cdot 2H_2O$, $Ni(NO_3)_2 \cdot 6H_2O$, $NiSO_4$, $NiSO_4 \cdot 6H_2O$, and nickel sulfide, and the cobalt precursor may be at least one selected from the group consisting of $Co(OH)_2$, $Co_3O_4$, $CoOOH$, $Co(OCOCH_3)_2 \cdot 4H_2O$, $Co(N-O_3)_2 \cdot 6H_2O$, and $Co(SO_4)_2 \cdot 7H_2O$. Also, the manganese precursor may be at least one selected from the group consisting of $Mn_2O_3$, $MnO_2$, $Mn_3O_4$, $MnCO_3$, $Mn(NO_3)_2$, $MnSO_4 \cdot H_2O$, manganese acetate, manganese halide, and manganese sulfide.

In this case, an amount of each transition metal precursor added may be determined in consideration of the molar ratio of the transition metal in the positive electrode material to be finally prepared.

The ammonium cationic complexing agent may include at least one compound selected from the group consisting of $NH_4OH$, $(NH_4)_2SO_4$, $NH_4NO_3$, $NH_4Cl$, $CH_3COONH_4$, and $(NH_4)_2CO_3$, and may be added into the reactor in the form of a solution in which the above compound is dissolved in a solvent. In this case, water or a mixture of water and an organic solvent (specifically, alcohol etc.), which may be uniformly mixed with the water, may be used as the solvent.

The basic compound may be at least one compound selected from the group consisting of NaOH, KOH, and $Ca(OH)_2$, and may be added into the reactor in the form of a solution in which the above compound is dissolved in a solvent. In this case, water or a mixture of water and an organic solvent (specifically, alcohol etc.), which may be uniformly mixed with the water, may be used as the solvent.

If the transition metal-containing solution, the ammonium cationic complexing agent, and the basic compound are added to the reactor and stirred as described above, precursor particles in the form of a transition metal hydroxide are formed while the transition metals in the transition metal-containing solution are co-precipitated.

In this case, the transition metal-containing solution, the ammonium cationic complexing agent, and the basic compound are added in amounts such that a pH of a reaction solution is within a desired range.

If the precursor particles are formed by the above-described method, a precursor is obtained by separating the particles from the reaction solution. For example, after separating the precursor from the reaction solution by filtering the reaction solution, the separated precursor may be washed and dried to obtain a precursor. In this case, a process, such as grinding and/or classification, may be performed, if necessary.

As the lithium raw material, lithium-containing sulfates, nitrates, acetic acid salts, carbonates, oxalates, citrates, halides, hydroxides, or oxyhydroxides may be used, and, for example, $Li_2CO_3$, $LiNO_3$, $LiNO_2$, $LiOH$, $LiOH \cdot H_2O$, $LiH$, $LiF$, $LiCl$, $LiBr$, $LiI$, $CH_3COOLi$, $Li_2O$, $Li_2SO_4$, $CH_3COOLi$, $Li_3C_6H_5O_7$, or a mixture thereof may be used.

The lithium raw material and the transition metal-containing precursor may be mixed such that a molar ratio of lithium (Li) :total metals in the precursor is in a range of 1:1 to 1.2:1, preferably, 1:1 to 1.1:1. When the mixing ratio of the lithium raw material to the metals in the precursor satisfies the above range, since a layered crystal structure of the lithium composite transition metal oxide is well developed, a positive electrode material having excellent capacity characteristics and structural stability may be prepared.

2) Second Step

After the first step, a step of preparing a first sintered body by performing primary sintering on the first mixture prepared in the first step at 500°C to 900°C and performing secondary sintering at 700°C to 1,000°C is performed.

The primary sintering may be performed at 500°C to 900°C, preferably 550°C to 800°C, and more preferably 600°C to 650°C in an oxygen atmosphere. The primary sintering may be performed for 1 hour to 2 hours.

The primary sintering is a process of pre-sintering by mixing the lithium source with the precursor, wherein in a case in which the primary sintering is performed at 500°C or higher, since moisture in the precursor and the lithium source evaporates to increase an input amount, it is desirable in terms of reducing processing costs. However, since an excessive increase in the sintering temperature may inhibit lithiation, it is desirable that the sintering temperature is not greater than 900°C.

The secondary sintering may be performed at 700°C to 1,000°C, preferably 720°C to 900°C, and more preferably 750°C to 850°C in an oxygen atmosphere. The secondary sintering may be performed for 4 hours to 6 hours.

The secondary sintering is a step in which a basic layered structure of the positive electrode active material is completed and an overall level of degree of single crystallinity is determined. Thus, considering that the higher the sintering temperature is, the better the particle growth reaction occurs to increase the degree of single particle formation, it is desirable that the secondary sintering temperature is 700°C or higher. However, if an amount of $Li_2O$ is increased due to high-temperature sintering, it is easily converted to LiOH, and, since the LiOH may be easily converted to $Li_2CO_3$ to cause the side reaction with the electrolyte solution and gas generation, it is desirable that the secondary sintering temperature is 1,000°C or less. In the present specification, the oxygen atmosphere means an atmosphere containing enough oxygen for sintering including an air atmosphere. Particularly, it is desirable to perform the sintering in an atmosphere in which an oxygen partial pressure is higher than that of the air atmosphere.

In a case in which the sintering is performed two or more times after the addition of the lithium raw material as described above, since the input amount may be increased, it is desirable in terms of reducing the processing costs.

3) Third Step

After the second step, the first sintered body is mixed with a zirconium raw material to prepare a second mixture.

In a case in which the zirconium raw material and the lithium raw material are added simultaneously and sintered at the same time, there is a problem in that doping occurs non-uniformly because appropriate temperature during doping and temperature during sintering are not matched. In contrast, in a case in which, after adding the lithium raw material and then performing sintering, a process of adding the zirconium raw material and performing sintering again is performed as in the present invention, this problem may be solved.

The zirconium raw material may be at least one selected from the group consisting of $ZrO_2$, $Zr(OH)_4$, and $Zr(SO_4)_2$.

The zirconium raw material may be mixed in an amount such that the weight of the zirconium is in a range of 300 ppm to 1,000 ppm based on the total weight of the lithium composite transition metal oxide.

4) Fourth Step

After the third step, a step of preparing a second sintered body in a form of a single particle or a pseudo-single particle by performing tertiary sintering on the second mixture at 650°C to 900°C and performing quaternary sintering at 650° C to 950°C is performed.

The tertiary sintering may be performed at 650°C to 900°C, preferably 670°C to 880°C, and more preferably 700°C to 850°C in an oxygen atmosphere. The tertiary sintering may be performed for 6 hours to 10 hours.

The tertiary sintering is a step in which doping occurs, wherein, in a case in which the tertiary sintering temperature is within the above range, since doping occurs uniformly, there is an effect of improving crystallinity.

The quaternary sintering may be performed at 650°C to 950°C, preferably 670°C to 930°C, and more preferably 700°C to 900°C in an oxygen atmosphere. The quaternary sintering may be performed for 4 hours to 8 hours.

The quaternary sintering is a step in which a high-temperature heat treatment is performed, wherein, since the higher the sintering temperature is, the more uniformly the primary particle grows to form a uniform particle surface and have an effect of reducing the fine powder generation amount, it is desirable that the quaternary sintering temperature is 650°C or higher. However, if the sintering temperature is excessively increased, growth becomes non-uniform and it is difficult to achieve the target particle size, it is desirable that the quaternary sintering temperature is not greater than 950°C.

A grinding process may be performed between the tertiary sintering and the quaternary sintering. In the case that the sintering is performed two or more times after the addition of the lithium raw material as described above, it is desirable in terms of preventing damage to the particle surface and reducing the fine powder generation amount.

5) Fifth Step

After the fourth step, a step of milling the second sintered body is performed.

The milling process is to remove large particles and obtain a particle size of the positive electrode material powder within a desired numerical range. Aggregation and/or agglomeration between adjacent particles may occur during the high-temperature sintering processes of the second and fourth steps to generate large particles, and this may lead to a deterioration in rolling properties. Thus, in the present invention, the large particles may be removed and positive electrode material powder having a final desired $D_{50}$ may be formed by performing the milling process.

As described above, since the present invention uses the precursor having a limited particle size, the milling conditions may be relaxed to reduce an impact force applied to the sintered body and reduce the fine powder generation amount.

The milling may be performed using a common milling method known in the art, for example, a jet-mill method. The milling, for example, may be performed at a speed of 1,500 rpm to 3,000 rpm, specifically, 1,500 rpm to 2,500 rpm, wherein the speed refers to a classifier speed.

It is desirable that the milling is performed in an atmosphere with low moisture content, for example, in a dry air atmosphere. The reason for this is that, when the lithium composite transition metal oxide is exposed to moisture, generation of a lithium byproduct is increased and surface properties of the active material may be deteriorated.

**Positive Electrode**

Next, a positive electrode according to the present invention will be described.

The positive electrode according to the present invention includes the above-described positive electrode material powder. Specifically, the positive electrode includes a positive electrode collector; and a positive electrode active material layer which is disposed on the positive electrode collector and includes the above positive electrode material powder. Since the positive electrode material powder has been described above, a description of the positive electrode material powder will be omitted and components excluding the positive electrode material powder will be described below.

In the positive electrode, the positive electrode collector is not particularly limited as long as it has conductivity without causing adverse chemical changes in the battery, and, for example, stainless steel, aluminum, nickel, titanium, fired carbon, or aluminum or stainless steel that is surface-treated with one of carbon, nickel, titanium, silver, or the like may be used. Also, the positive electrode collector may typically have a thickness of 3 $\mu$m to 500 $\mu$m, and microscopic irregularities may be formed on the surface of the collector to improve the adhesion of the positive electrode material powder. The positive electrode collector, for example, may be used in various shapes such as that of a film, a sheet, a foil, a net, a porous body, a foam body, a nonwoven fabric body, and the like.

Also, the positive electrode active material layer may include a conductive agent and a binder in addition to the above-described positive electrode material powder.

The positive electrode material powder may be typically included in an amount of 80 wt% to 99 wt%, preferably 90 wt% to 98 wt%, and more preferably 95 wt% to 97 wt% based on a total weight of the positive electrode active material layer.

The conductive agent is used to provide conductivity to the electrode, wherein any conductive agent may be used without particular limitation as long as it has suitable electron conductivity without causing adverse chemical changes in the battery. Specific examples of the conductive agent may be graphite such as natural graphite or artificial graphite; carbon black such as acetylene black, Ketjen black, channel black, furnace black, lamp black, and thermal black; carbon-based materials such as carbon fibers and carbon nanotubes; powder or fibers of metal such as copper, nickel, aluminum, and silver; conductive whiskers such as zinc oxide whiskers and potassium titanate whiskers; conductive metal oxides such as titanium oxide; or conductive polymers such as polyphenylene derivatives, and any one thereof or a mixture of two or more thereof may be used. The conductive agent may be typically included in an amount of 0.5 wt% to 20 wt%, preferably 1 wt% to 10 wt%, and more preferably 1 wt% to 5 wt% based on the total weight of the positive electrode active material layer.

The binder improves the adhesion between the positive electrode active material particles and the adhesion between the positive electrode active material and the positive electrode collector. Specific examples of the binder may be polyvinylidene fluoride (PVDF), polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer rubber (EPDM rubber), a sulfonated EPDM, a styrene-butadiene rubber (SBR), a fluorine rubber, or various copolymers thereof, and any one thereof or a mixture of two or more thereof may be used. The binder may be included in an amount of 0.5 wt% to 20 wt%, preferably 1 wt% to 10 wt%, and more preferably 1 wt% to 5 wt% based on the total weight of the positive electrode active material layer.

The positive electrode may be prepared according to a typical method of preparing a positive electrode. For example, after a positive electrode slurry is prepared by mixing the positive electrode material powder, the binder, and/or the conductive agent in a solvent and is coated on the positive electrode collector, the positive electrode may be prepared by drying and rolling the coated positive electrode collector.

The solvent may be a solvent normally used in the art. The solvent may include dimethyl sulfoxide (DMSO), isopropyl alcohol, N-methylpyrrolidone (NMP), acetone, or water, and any one thereof or a mixture of two or more thereof may be used. An amount of the solvent used may be sufficient if the solvent may dissolve or disperse the positive electrode material powder, the conductive agent, and the binder in consideration of a coating thickness of the slurry and manufacturing yield, and may allow to have viscosity that may provide excellent thickness uniformity during the subsequent coating for the preparation of the positive electrode.

As another method, the positive electrode may be prepared by casting the positive electrode slurry on a separate support and then laminating a film separated from the support on the positive electrode collector.

**Lithium Secondary Battery**

Next, a lithium secondary battery according to the present invention will be described.

The lithium secondary battery specifically includes a positive electrode, a negative electrode including a negative electrode active material, a separator disposed between the positive electrode and the negative electrode, and an electrolyte. Since the positive electrode is the same as described above, detailed descriptions thereof will be omitted, and the remaining configurations will be only described in detail below.

Also, the lithium secondary battery may further optionally include a battery container accommodating an electrode assembly of the positive electrode, the negative electrode, and the separator, and a sealing member sealing the battery container.

In the lithium secondary battery, the negative electrode includes a negative electrode collector and a negative electrode active material layer disposed on the negative electrode collector.

The negative electrode collector is not particularly limited as long as it has high conductivity without causing adverse chemical changes in the battery, and, for example, copper, stainless steel, aluminum, nickel, titanium, fired carbon, copper or stainless steel that is surface-treated with one of carbon, nickel, titanium, silver, or the like, and an aluminum-cadmium alloy may be used. Also, the negative electrode collector may typically have a thickness of 3 $\mu$m to 500 $\mu$m, and, similar to the positive electrode collector, microscopic irregularities may be formed on the surface of the collector to improve the adhesion of the negative electrode active material. The negative electrode collector, for example, may be used in various shapes such as that of a film, a sheet, a foil, a net, a porous body, a foam body, a nonwoven fabric body, and the like.

The negative electrode active material layer optionally includes a binder and a conductive agent in addition to the negative electrode active material.

A compound capable of reversibly intercalating and deintercalating lithium may be used as the negative electrode active material. Specific examples of the negative electrode active material may be a carbonaceous material such as artificial graphite, natural graphite, graphitized carbon fibers, and amorphous carbon; a metallic compound alloyable with lithium such as silicon (Si), aluminum (Al), tin (Sn), lead (Pb), zinc (Zn), bismuth (Bi), indium (In), magnesium (Mg), gallium (Ga), cadmium (Cd), a Si alloy, a Sn alloy, or an Al alloy; a metal oxide which may be doped and undoped with lithium such as $SiO_\beta(0<\beta<2)$, $SnO_2$, vanadium oxide, and lithium vanadium oxide; or a composite including the metallic compound and the carbonaceous material such as a Si-C composite or a Sn-C composite, and any one thereof or a mixture of two or more thereof may be used.

In an embodiment of the present invention, the negative electrode active material may be graphite, the Si-containing material, or a mixture thereof, may specifically be graphite, and may more specifically be a mixture of artificial graphite and natural graphite. Also, a metallic lithium thin film may be used as the negative electrode active material. The negative electrode active material may be included in an amount of 80 wt% to 99 wt% based on a total weight of the negative electrode active material layer.

The binder is a component that assists in the binding between the conductive agent, the active material, and the current collector, wherein the binder is typically added in an amount of 0.1 wt% to 10 wt% based on the total weight of the negative electrode active material layer. Examples of the binder may be polyvinylidene fluoride (PVDF), polyvinyl alcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated-EPDM, a styrene-butadiene rubber, a nitrile-butadiene rubber, a fluorine rubber, and various copolymers thereof.

The conductive agent is a component for further improving conductivity of the negative electrode active material, wherein the conductive agent may be included in an amount of 10 wt% or less, preferably, 5 wt% or less based on the total weight of the negative electrode active material layer. The conductive agent is not particularly limited as long as it has conductivity without causing adverse chemical changes in the battery, and, for example, a conductive material such as: graphite such as natural graphite or artificial graphite; carbon black such as acetylene black, Ketjen black, channel black, furnace black, lamp black, and thermal black; conductive fibers such as carbon fibers or metal fibers; fluorocarbon; metal powder such as aluminum powder and nickel powder; conductive whiskers such as zinc oxide whiskers and potassium titanate whiskers; conductive metal oxide such as titanium oxide; or polyphenylene derivatives may be used.

The negative electrode active material layer may be prepared by coating a negative electrode material mixture, which is prepared by dissolving or dispersing optionally the binder and the conductive agent as well as the negative electrode active material in a solvent, on the negative electrode collector and drying the coated negative electrode collector, or may be prepared by casting the negative electrode material mixture on a separate support and then laminating a film separated from the support on the negative electrode collector.

In the lithium secondary battery, the separator separates the negative electrode and the positive electrode and provides a movement path of lithium ions, wherein any separator may be used as the separator without particular limitation as long as it is typically used in a lithium secondary battery, and particularly, a separator having high moisture-retention ability for an electrolyte as well as low resistance to the transfer of electrolyte ions may be used. Specifically, a porous polymer film, for example, a porous polymer film prepared from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. Also, a typical porous nonwoven fabric, for example, a nonwoven fabric formed of high melting point glass fibers or polyethylene terephthalate fibers may be used. Furthermore, a coated separator including a ceramic component or a polymer material may be used to secure heat resistance or mechanical strength, and the separator having a single layer or multilayer structure may be optionally used.

Also, the electrolyte used in the present invention may include an organic liquid electrolyte, an inorganic liquid electrolyte, a solid polymer electrolyte, a gel-type polymer electrolyte, a solid inorganic electrolyte, or a molten-type inorganic electrolyte which may be used in the preparation of the lithium secondary battery, but the present invention is not limited thereto.

Specifically, the electrolyte may include an organic solvent and a lithium salt.

Any organic solvent may be used as the organic solvent without particular limitation so long as it may function as a medium through which ions involved in an electrochemical reaction of the battery may move. Specifically, an ester-based solvent such as methyl acetate, ethyl acetate, $\gamma$-butyrolactone, and $\varepsilon$-caprolactone; an ether-based solvent such as dibutyl ether or tetrahydrofuran; a ketone-based solvent such as cyclohexanone; an aromatic hydrocarbon-based solvent such as benzene and fluorobenzene; or a carbonate-based solvent such as dimethyl carbonate (DMC), diethyl carbonate (DEC), ethylmethyl carbonate (EMC), ethylene carbonate (EC), and propylene carbonate (PC); an alcohol-based solvent such as ethyl alcohol and isopropyl alcohol; nitriles such as R-CN (where R is a linear, branched, or cyclic C2-C20 hydrocarbon group and may include a double-bond aromatic ring or ether bond); amides such as dimethylformamide; dioxolanes such as 1,3-dioxolane; or sulfolanes may be used as the organic solvent. Among these solvents, the carbonate-based solvent is preferable, and a mixture of a cyclic carbonate (e.g., ethylene carbonate or propylene carbonate) having high ionic conductivity and high dielectric constant, which may increase charge/discharge performance of the battery, and a low-viscosity linear carbonate-based compound (e.g., ethylmethyl carbonate, dimethyl carbonate, or diethyl carbonate) is more preferable.

The lithium salt may be used without particular limitation as long as it is a compound capable of providing lithium ions used in the lithium secondary battery. Specifically, an anion of the lithium salt may be at least one selected from the group consisting of $F^-$, $Cl^-$, $Br^-$, $I^-$, $NO_3^-$, $N(CN)_2^-$, $BF_4^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_3)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$, and $LiPF_6$, $LiClO_4$, $LiAsF_6$, $LiBF_4$, $LiSbF_6$, $LiAlO_2$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, or $LiB(C_2O_4)_2$ may be used as the lithium salt. The lithium salt may be used in a concentration range of 0.1 M to 4.0 M. If the concentration of the lithium salt is included within the above range, since the electrolyte may have appropriate conductivity and viscosity, excellent performance of the electrolyte may be obtained and lithium ions may effectively move.

In order to improve life characteristics of the battery, suppress a reduction in battery capacity, and improve discharge capacity of the battery, at least one additive, for example, a halo-alkylene carbonate-based compound such as difluoroethylene carbonate, pyridine, triethylphosphite, triethanolamine, cyclic ether, ethylenediamine, n-glyme, hexa methylphosphorictriamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte in addition to the electrolyte components. In this case, the additive may be included in an amount of 0.1 wt% to 5 wt% based on a total weight of the electrolyte.

A shape of the lithium secondary battery of the present invention is not particularly limited, but a cylindrical type using a can, a prismatic type, a pouch type, or a coin type may be used.

As described above, since the lithium secondary battery including the positive electrode material powder according to the present invention stably exhibits high-temperature performance, the lithium secondary battery may not only be used in a battery cell that is used as a power source of a small device such as mobile phones, notebook computers, and digital cameras, but may also be preferably used as a unit cell of a battery module for a medium and large sized device which includes a plurality of battery cells.

Examples of the medium and large sized device may be a power tool, an electric vehicle, a hybrid electric vehicle, a plug-in hybrid electric vehicle, and a power storage system, but the medium and large sized device is not limited thereto.

According to another embodiment of the present invention, a battery module including the lithium secondary battery as a unit cell and a battery pack including the battery module are provided.

Hereinafter, examples of the present invention will be described in detail in such a manner that it may easily be carried out by a person with ordinary skill in the art to which the present invention pertains.

**[Examples: Preparation of Positive Electrode Material Powders]**

**Example 1.**

A precursor having a $D_{50}$ of about 3.7 $\mu$m and a composition represented by $Ni_{0.960}Co_{0.030}Mn_{0.010}(OH)_2$ and LiOH were put into a Henschel mixer (700 L) in amounts such that a molar ratio of (Ni+Co+Mn):Li was 1:1.05, and were mixed at a center speed of 400 rpm for 20 minutes. The mixed powder was put into an alumina crucible having a size of 330 mm $\times$ 330 mm, sintered at a temperature of 610°C for 2 hours in an oxygen ($O_2$) atmosphere, and then sintered again at 830°C for 4 hours.

The sintered powder and $ZrO_2$ were put again into the Henschel mixer (700 L) and mixed at a center speed of 400 rpm for 20 minutes. In this case, the $ZrO_2$ was added in an amount such that a weight of Zr was 500 ppm based on a total weight of a lithium composite transition metal oxide finally obtained. The mixed powder was put into an alumina crucible having a size of 330 mm $\times$ 330 mm, sintered at a temperature of 780°C for 8 hours in an oxygen ($O_2$) atmosphere, subjected to primary grinding, and then sintered again at 800°C for 6 hours.

Positive electrode material powder having a composition of $Li[Ni_{0.9595}Co_{0.0300}Mn_{0.0100}Zr_{0.0005}]O_2$ was prepared by milling the sintered powder at a classification speed of 2,300 rpm in a dry air atmosphere using a jet-mill device.

**Comparative Example 1.**

A precursor having a $D_{50}$ of about 4.0 $\mu$m and a composition represented by $Ni_{0.960}Co_{0.030}Mn_{0.010}(OH)_2$ and LiOH were put into a Henschel mixer (700 L) in amounts such that a molar ratio of (Ni+Co+Mn):Li was 1:1.05, and were mixed at a center speed of 400 rpm for 20 minutes. The mixed powder was put into an alumina crucible having a size of 330 mm $\times$ 330 mm, sintered at a temperature of 610°C for 2 hours in an oxygen ($O_2$) atmosphere, and then sintered again at 830°C for 4 hours. Positive electrode material powder having a composition of $Li[Ni_{0.960}Co_{0.030}Mn_{.0010}]O_2$ was prepared by milling the sintered powder at a classification speed of 2,300 rpm in a dry air atmosphere using a jet-mill device.

**Comparative Example 2.**

Positive electrode material powder was prepared in the same manner as in Comparative Example 1 except that a precursor having a $D_{50}$ of about 3.7 $\mu$m was used.

**Comparative Example 3.**

A precursor having a $D_{50}$ of about 3.7 $\mu$m and a composition represented by $Ni_{0.960}Co_{0.030}Mn_{0.010}(OH)_2$, LiOH, and $ZrO_2$ were simultaneously put into a Henschel mixer (700 L), and were mixed at a center speed of 400 rpm for 20 minutes. In this case, the LiOH was added in an amount such that a molar ratio of Li: (Ni+Co+Mn) was 1.05:1, and the $ZrO_2$ was added in an amount such that a weight of Zr was 500 ppm based on a total weight of a lithium composite transition metal oxide finally obtained. The mixed powder was put into an alumina crucible having a size of 330 mm $\times$ 330 mm, sintered at a temperature of 830°C for 4 hours in an oxygen ($O_2$) atmosphere, and then sintered at a temperature of 780°C for 10 hours. Positive electrode material powder having a composition of $Li[Ni_{0.9595}Co_{0.0300}Mn_{0.0100}Zr_{0.0005}]O_2$ was prepared by milling the sintered powder at a classification speed of 2,300 rpm in a dry air atmosphere using a jet-mill device.

**[Experimental Examples]**

**Experimental Example 1. Powder Characterization**

**(1) $D_{50}$ and SEM Observation**

After dispersing 0.1 g of each of the positive electrode material powders prepared in the example and the comparative examples in a dispersion medium, the dispersion medium was introduced into a commercial laser diffraction particle size measurement instrument (Malvern Panalytical Ltd., Mastersizer 3000) and irradiated with ultrasonic waves of about 28 kHz at an output of 60 W to measure $D_{50}$ of each positive electrode material powder. Measurement results are presented in Table 1 below.

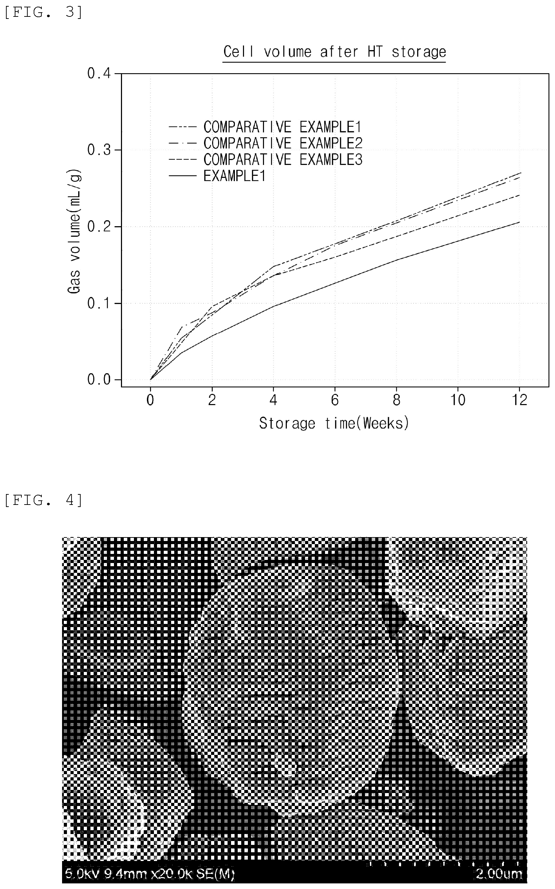

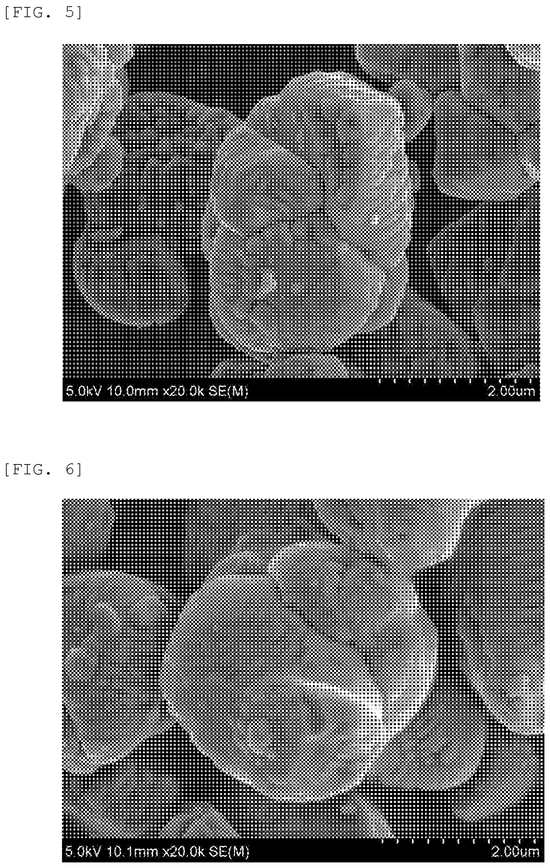

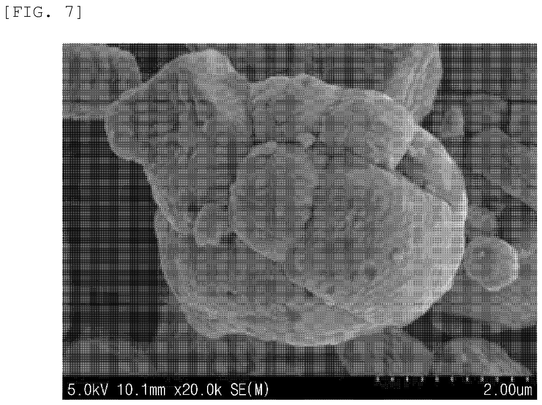

Also, a scanning electron microscope (SEM) image of each of the positive electrode material powders prepared in Example 1 and Comparative Examples 1 to 3 was obtained by using a scanning electron microscope, and these images are illustrated in FIGS. 4 to 7, respectively.

**(2) Measurement of Degree of Single Particle Formation**

Each of the positive electrode material powders prepared in the example and the comparative examples, carbon black, and a PVDF binder were mixed in N-methylpyrrolidone in a weight ratio of 95:2:3 to prepare an electrode slurry. One surface of an aluminum current collector was coated with the electrode slurry and then dried at 130°C to prepare an electrode for EBSD analysis. Rolling was not performed during the preparation of the positive electrode.

The positive electrode was cross-sectioned using an ion milling device (HITACHI IM-5000, accelerating voltage 6 kV), and EBSD analysis was performed on the cross section of the positive electrode using a FE-SEM (JEOL JSM7900F) equipped with an electron backscatter diffraction (EBSD) pattern analyzer. The EBSD analysis was performed on a scale with the total number of grains of about 400+/-10 at an accelerating voltage of 15 kV and a W.D. of 15 mm.

A diameter of a grain in each particle observed in each cross-section of the positive electrode was measured by the EBSD analysis, a half of the maximum diameter of the measured grain was calculated as a radius of the grain, and an arithmetic mean value of the diameters of the measured grains was calculated as an average grain diameter. Also, a degree of single particle formation was calculated by substituting the radius of the grain and the $D_{50}$ measured in (1) above into [Equation 1]. Measurement results are presented in Table 1 below.

### (3) Measurements of Tap Density, Pellet Density and Fine Powder Generation Rate

Tap density of each of the positive electrode material powders prepared in the example and the comparative examples was measured using a GEOPYC 1360 tap density analyzer by Micromeritics Instrument Corporation. Specifically, 10 g of each of the positive electrode material powders prepared in the example and the comparative examples was collected and filled into a container having a diameter of 19 mm, the container was vibrated horizontally until a force of 108 N was applied to measure the tap density, and it was listed in Table 1 below.

Also, 3 g of each of the positive electrode material powders prepared in Example 1 and Comparative Examples 1 to 3 was collected and put in a circular mold having a diameter of 13 mm, and a height of a pellet formed was measured every 1,500 kgf while a force was applied until the force became 12,000 kgf using an automatic pellet press (Auto Pellet Press, Carver, Inc., 3887.4). A volume of the pellet was calculated based on the measured height, and pellet density, which was calculated by dividing the weight of the positive electrode material powder by the volume of the pellet, was illustrated in FIG. 1.

Furthermore, a change in pellet density was calculated by substituting the calculated pellet density into [Equation 2] and it was listed in Table 1 below.

After the pellet pressed by a force of 12,000 kgf was dispersed again in a dispersion medium, a volume cumulative particle size distribution (PSD) was obtained by using a laser diffraction particle size measurement instrument (e.g., Malvern Panalytical Ltd., Mastersizer 3000). A volume ratio of fine powder with a particle diameter of 1 $\mu$m or less among the entire positive electrode material powder was calculated based on the PSD, and this was listed as a fine powder generation rate in Table 1 below.

[Table 1]

| | $D_{50}$ of precursor [$\mu$m] | $D_{50}$ of positive electrode material powder [$\mu$m] | Average grain diameter[$\mu$m] | Degree of single particle formation of Equation 1 | Tap density [g/cc] | Change in pellet density of Equation 2 | Fine powder generation rate [vol%] |
|---|---|---|---|---|---|---|---|
| Example 1 | 3.7 | 4.02 | 2.31 | 3.05 | 2.07 | 2.13 | 1.32 |
| Comparative Example 1 | 4.0 | 4.14 | 1.94 | 1.80 | 1.55 | 3.31 | 5.18 |
| Comparative Example 2 | 3.7 | 4.07 | 2.04 | 1.85 | 1.60 | 3.12 | 2.36 |
| Comparative Example 3 | 3.7 | 3.95 | 2.10 | 2.47 | 1. 87 | 2.37 | 1. 91 |

According to results of FIG. 1 and Table 1, it may be confirmed that the positive electrode material powder having a degree of single particle formation of 2.5 to 4.5 and a change in pellet density of 2.5 or less was prepared in Example 1 in which Zr doping was performed and the $D_{50}$ of the precursor and the $D_{50}$ of the positive electrode material powder satisfied Equation 3. It may be confirmed that the positive electrode material powders having a degree of single particle formation of less than 2.5 were prepared in Comparative Example 1, in which Equation 3 was not satisfied and Zr doping was not performed, and Comparative Example 2 in which Equation 3 was satisfied, but Zr doping was not performed, and the positive electrode material powder having a degree of single particle formation of less than 2.5 was prepared in Comparative Example 3 in which Zr doping was performed and Equation 3 was satisfied, but the lithium raw material and the zirconium raw material were simultaneously added and twice sintering were performed. Also, Comparative Examples 1 to 3 also exhibited higher changes in pellet density than Example 1, and particularly, with respect to Comparative Examples 1 and 2, it was found that the changes in pellet density were greater than 2.5. It was found that the positive electrode material powder prepared in Example 1 had a larger average grain diameter, higher tap density, and a lower fine powder generation rate than the positive electrode material powders prepared in Comparative Examples 1 to 3.

Particularly, in Comparative Example 1 in which the $D_{50}$ of the precursor and the $D_{50}$ of the positive electrode material powder did not satisfy Equation 3 and Zr doping was not performed, the positive electrode material powder having the smallest average grain diameter, the lowest tap density and degree of single particle formation, and the largest change in pellet density was prepared, and it may be confirmed that the fine powder generation rate was very high at 5 vol% or more.

**Experimental Example 2. Coin Cell Performance Evaluation**

**(1) Preparation of Coin Half-Cell**

Each of the lithium composite transition metal oxides prepared in the example and the comparative examples, carbon black as a conductive agent, and PVDF, as a binder, were mixed in a NMP solvent in a weight ratio of 95.0:2.0:3.0 to prepare a positive electrode slurry. One surface of an aluminum current collector was coated with the positive electrode slurry, dried at 130°C, and then rolled to prepare each positive electrode. A half-cell was prepared by preparing an electrode assembly by disposing a porous polyethylene separator between the prepared positive electrode and a lithium metal negative electrode, disposing the electrode assembly in a battery case, and then injecting an electrolyte solution into the case. The electrolyte solution was prepared by dissolving 1.0 M $LiPF_6$ in a mixed organic solvent in which ethylene carbonate:ethyl methyl carbonate:diethyl carbonate were mixed in a volume ratio of 3:4:3.

**(2) High-temperature Lifetime Evaluation**

After a formation process was performed on each of the half-cells prepared in (1) above, each half-cell was charged at 0.5 C (standard capacity 1 C = 200 mAh/g) to 4.25 V under constant current-constant voltage (CC-CV) conditions at 45°C using PNE-0506 charge/discharge equipment (manufacturer: PNE SOLUTION Co., Ltd.), and CC discharged at 1.0 C to 2.5 V. The above charging and discharging were defined as one cycle and, after initial discharge capacity was measured after one cycle, discharge capacity was measured while repeating the same charging and discharging up to 50 cycles. Based on this, capacity retention relative to the initial discharge capacity was calculated, and the results thereof are illustrated in FIG. 2 and Table 2.

**(3) Gas Generation Amount Evaluation**

After a formation process was performed on each of the half-cells prepared in (1) above, each half-cell was charged at 0.5 C (standard capacity 1 C = 200 mAh/g) to 4.25 V under CC-CV conditions at 45°C using PNE-0506 charge/discharge equipment (manufacturer: PNE SOLUTION Co., Ltd.), and CC discharged at 1.0 C to 2.5 V. Thereafter, while storing each half-cell in a chamber at 60°C, the half-cell was taken out of the chamber at one-week intervals and a change in volume was calculated by applying the Archimedes principle using a hydrometer (MATSUHAKU, TWD-150DM). The results thereof are illustrated in FIG. 3, and results of calculating a gas generation amount per weight by dividing an amount of change in volume after 12 weeks by a weight of the positive electrode material are listed in Table 2 below.

[Table 2]

|  | Capacity retention [%] | Gas generation amount [mL/g] |
|---|---|---|
| Example 1 | 91.7 | 0.206 |
| Comparative Example 1 | 86.1 | 0.296 |
| Comparative Example 2 | 89.6 | 0.263 |
| Comparative Example 3 | 89.9 | 0.240 |

According to FIG. 2, FIG. 3, and Table 2, it may be confirmed that the cell using the positive electrode material powder of Example 1 exhibited better evaluation results in terms of high-temperature life and high-temperature storage characteristics than the cells using the positive electrode material powders of Comparative Examples 1 to 3.

**Claims**

1.   A positive electrode material powder comprising:

a lithium composite transition metal oxide including nickel, cobalt, manganese, and zirconium,
wherein a degree of single particle formation defined by Equation 1 is in a range of 2.5 to 4.5:

[Equation 1]

$$\frac{\sum_{i=1}^{n} \frac{4\pi}{3} \times R_i^3}{n}$$

wherein, in Equation 1,

$R_i$ is a radius ($\mu$m) of an $i^{th}$ grain which is measured when an electrode prepared by using the positive electrode material powder is analyzed by electron backscatter diffraction (EBSD) after an ion-milling treatment, and
n is the total number of grains measured by the EBSD analysis, wherein n is in a range of 350 to 450.

2. The positive electrode material powder of claim 1, wherein a change in pellet density defined by Equation 2 of the positive electrode material powder is 2.5 or less:

[Equation 2]

$$\{(P_{12ton}-P_{1.5ton})/10.5\} \times 20$$

wherein, in Equation 2,

$P_{1.5ton}$ is pellet density (g/cc) obtained by dividing the weight of the positive electrode material powder by the volume of a pellet prepared by putting the positive electrode material powder in a circular mold with a diameter of 13 mm and pressing the powder with a force of 1,500 kgf, and
$P_{12ton}$ is pellet density (g/cc) obtained by dividing the weight of the positive electrode material powder by the volume of the pellet prepared by putting the positive electrode material powder in a circular mold with a diameter of 13 mm and pressing the powder with a force of 12,000 kgf.

3. The positive electrode material powder of claim 1, wherein a weight of the zirconium is in a range of 300 ppm to 1,000 ppm based on a total weight of the lithium composite transition metal oxide.

4. The positive electrode material powder of claim 1, wherein a $D_{50}$ of the positive electrode material powder is in a range of 3 $\mu$m to 6 $\mu$m.

5. The positive electrode material powder of claim 1, wherein a tap density of the positive electrode material powder is in a range of 1.8 g/cc to 2.3 g/cc.

6. The positive electrode material powder of claim 1, wherein an average grain diameter of the positive electrode material powder is in a range of 0.5 $\mu$m to 4.0 $\mu$m.

7. The positive electrode material powder of claim 1, wherein, when the positive electrode material powder is put in a circular mold having a diameter of 13 mm and pressed with a force of 12,000 kgf, a generation rate of fine powder having a particle diameter of 1 $\mu$m or less is 2 vol% or less based on a total volume of the positive electrode material powder.

8. The positive electrode material powder of claim 1, wherein the lithium composite transition metal oxide has a composition of Formula 1:

[Formula 1]     $Li_{1+x}(Ni_aCo_bMn_cZr_dM1_e)O_2$

wherein, in Formula 1,

M1 is at least one selected from the group consisting of Al, Ti, W, Mo, Nb, Cu, Fe, V, Cr, Zn, In, Ta, Y, La, Sr, Ga, Sc, Gd, Sm, Ca, Ce, Mg, and B, and

x, a, b, c, d, and e respectively satisfy $0 \leq x \leq 0.50$, $0.55 \leq a < 1$, $0 < b \leq 0.40$, $0 < c \leq 0.40$, $0 < d \leq 0.01$, $0 \leq e \leq 0.10$, and a+b+c+d+e=1.

9. The positive electrode material powder of claim 1, wherein an amount of the nickel among metals excluding lithium of the lithium composite transition metal oxide is 70 mol% or more.

10. A method of preparing positive electrode material powder, comprising:

a first step of preparing a first mixture by mixing a transition metal-containing precursor including nickel, cobalt, and manganese with a lithium raw material;

a second step of preparing a first sintered body by performing primary sintering on the first mixture at 500°C to 900°C and performing secondary sintering at 700°C to 1,000°C;

a third step of preparing a second mixture by mixing the first sintered body with a zirconium raw material;

a fourth step of preparing a second sintered body in a form of a single particle or a pseudo-single particle by performing tertiary sintering on the second mixture at 650°C to 900°C and performing quaternary sintering at 650°C to 950°C; and

a fifth step of milling the second sintered body,

wherein the method satisfies Equation 3:

$$[\text{Equation 3}]$$

$$A \leq 0.95B$$

wherein, in Equation 3,

A is $D_{50}$ of the transition metal-containing precursor, and
B is $D_{50}$ of the positive electrode material powder.

11. The method of claim 10, wherein the milling of the fifth step is performed at a speed of 1,500 rpm to 3,000 rpm.

12. The method of claim 10, wherein B of Equation 3 is in a range of 3 $\mu$m to 6 $\mu$m.

13. A positive electrode comprising the positive electrode material powder of claim 1.

14. A lithium secondary battery comprising the positive electrode of claim 13; a negative electrode including a negative electrode active material; a separator disposed between the positive electrode and the negative electrode; and an electrolyte.

[FIG. 1]

Pellet Density

[FIG. 2]

CHC cycle(45℃,0.5C/1.0C)

[FIG. 3]

## Cell volume after HT storage

[FIG. 4]

[FIG. 5]

[FIG. 6]

[FIG. 7]

5.0kV 10.1mm x20.0k SE(M)                    2.00um

## INTERNATIONAL SEARCH REPORT

| | |
|---|---|
| International application No. | **PCT/KR2024/015134** |

| A. | CLASSIFICATION OF SUBJECT MATTER |
|---|---|

**H01M 4/525**(2010.01)i; **H01M 4/505**(2010.01)i; **C01G 53/00**(2006.01)i; **H01M 4/131**(2010.01)i; **H01M 10/052**(2010.01)i; **H01M 4/02**(2006.01)i

According to International Patent Classification (IPC) or to both national classification and IPC

| B. | FIELDS SEARCHED |
|---|---|

Minimum documentation searched (classification system followed by classification symbols)

H01M 4/525(2010.01); C01G 53/00(2006.01); H01M 10/052(2010.01); H01M 4/48(2010.01); H01M 4/505(2010.01); H01M 4/58(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 양극재 (cathode material), 지르코늄 (zirconium, Zr), 단입자화도 (single particle degree), 소성 (sintering), 이차전지 (secondary battery)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2019-0078498 A (POSCO et al.) 04 July 2019 (2019-07-04)<br>See abstract; paragraphs [0107] and [0111]; and claims 19-21. | 1-14 |
| A | KR 10-2011-0021384 A (KOREA INSTITUTE OF SCIENCE AND TECHNOLOGY) 04 March 2011 (2011-03-04)<br>See abstract; and claims 1-14. | 1-14 |
| A | KR 10-2021-0155367 A (LG CHEM, LTD.) 22 December 2021 (2021-12-22)<br>See abstract; and claims 1-12. | 1-14 |
| A | KR 10-2023-0107145 A (LG ENERGY SOLUTION, LTD.) 14 July 2023 (2023-07-14)<br>See abstract; and claims 1-12. | 1-14 |
| A | JP 2003-034538 A (MITSUBISHI CHEMICALS CORP.) 07 February 2003 (2003-02-07)<br>See abstract; and claims 1-13. | 1-14 |

| ☐ Further documents are listed in the continuation of Box C. | ☑ See patent family annex. |
|---|---|

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 January 2025** | **13 January 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| International application No. |
| --- |
| **PCT/KR2024/015134** |

| Patent document cited in search report | | | Publication date (day/month/year) | Patent family member(s) | | | Publication date (day/month/year) |
| --- | --- | --- | --- | --- | --- | --- | --- |
| KR | 10-2019-0078498 | A | 04 July 2019 | CN | 111771303 | A | 13 October 2020 |
| | | | | CN | 111771303 | B | 29 March 2024 |
| | | | | EP | 3734720 | A1 | 04 November 2020 |
| | | | | JP | 2021-509220 | A | 18 March 2021 |
| | | | | JP | 7008828 | B2 | 25 January 2022 |
| | | | | KR | 10-2177049 | B1 | 10 November 2020 |
| | | | | US | 11973221 | B2 | 30 April 2024 |
| | | | | US | 2023-0140577 | A1 | 04 May 2023 |
| | | | | WO | 2019-132332 | A1 | 04 July 2019 |
| KR | 10-2011-0021384 | A | 04 March 2011 | KR | 10-1134566 | B1 | 13 April 2012 |
| KR | 10-2021-0155367 | A | 22 December 2021 | CN | 115066398 | A | 16 September 2022 |
| | | | | CN | 115066398 | B | 02 August 2024 |
| | | | | EP | 4091990 | A1 | 23 November 2022 |
| | | | | JP | 2023-515154 | A | 12 April 2023 |
| | | | | JP | 7366487 | B2 | 23 October 2023 |
| | | | | KR | 10-2509141 | B1 | 14 March 2023 |
| | | | | US | 12126019 | B2 | 22 October 2024 |
| | | | | US | 2023-0083070 | A1 | 16 March 2023 |
| | | | | WO | 2021-256794 | A1 | 23 December 2021 |
| KR | 10-2023-0107145 | A | 14 July 2023 | CN | 118511323 | A | 16 August 2024 |
| | | | | EP | 4443563 | A1 | 09 October 2024 |
| | | | | JP | 2024-545475 | A | 06 December 2024 |
| | | | | US | 2023-0223526 | A1 | 13 July 2023 |
| | | | | WO | 2023-132685 | A1 | 13 July 2023 |
| JP | 2003-034538 | A | 07 February 2003 | JP | 2007-238437 | A | 20 September 2007 |
| | | | | JP | 4092950 | B2 | 28 May 2008 |
| | | | | JP | 4605175 | B2 | 05 January 2011 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230132929

- KR 1020240134975